(19) Europäisches Patentamt
European Patent Office
Office européen des brevets

(11) **EP 1 748 556 B1**

(12) **FASCICULE DE BREVET EUROPEEN**

(45) Date de publication et mention
de la délivrance du brevet:
**02.10.2019 Bulletin 2019/40**

(51) Int Cl.:
***H03H 9/17*** *(2006.01)* ***H03H 3/04*** *(2006.01)*
***H03H 9/02*** *(2006.01)*

(21) Numéro de dépôt: **06118082.4**

(22) Date de dépôt: **28.07.2006**

(54) **Structure résonante hybride**

Hybridresonanzstruktur

Hybrid resonant structure

(84) Etats contractants désignés:
**AT BE BG CH CY CZ DE DK EE ES FI FR GB GR
HU IE IS IT LI LT LU LV MC NL PL PT RO SE SI
SK TR**

(30) Priorité: **29.07.2005 FR 0552397**

(43) Date de publication de la demande:
**31.01.2007 Bulletin 2007/05**

(73) Titulaires:
• **TDK Electronics AG
81671 München (DE)**
• **Centre National de la Recherche Scientifique
75016 Paris (FR)**

(72) Inventeurs:
• **Ballandras, Sylvain, Jean
25000 Besancon (FR)**
• **Steichen, William
06330 Roquefort les Pin (FR)**
• **Masson, Jérémy
25720 Avanne (FR)**

(74) Mandataire: **Epping - Hermann - Fischer
Patentanwaltsgesellschaft mbH
Schloßschmidstraße 5
80639 München (DE)**

(56) Documents cités:
US-A- 4 642 508          US-A- 6 087 198
US-A1- 2001 028 285

EP 1 748 556 B1

**Description**

**DOMAINE TECHNIQUE**

L'invention appartient au domaine de la mesure à distance d'une grandeur physique, par l'intermédiaire notamment d'une liaison radiofréquence et d'un composant passif. Plus particulièrement, l'invention concerne les structures résonantes à ondes de volume au sein de films piézoélectriques. La structure selon l'invention est optimisée pour augmenter son facteur de qualité et son coefficient de couplage dans sa gamme de fréquence.

L'invention se rapporte également à un procédé de fabrication d'une telle structure hybride, et à diverses utilisations.

**ÉTAT DE LA TECHNIQUE ANTÉRIEURE**

Dans le domaine des transpondeurs et/ou capteurs, on utilise de façon croissante des dispositifs résonants à bande étroite, fonctionnant notamment dans la gamme des 500 MHz.

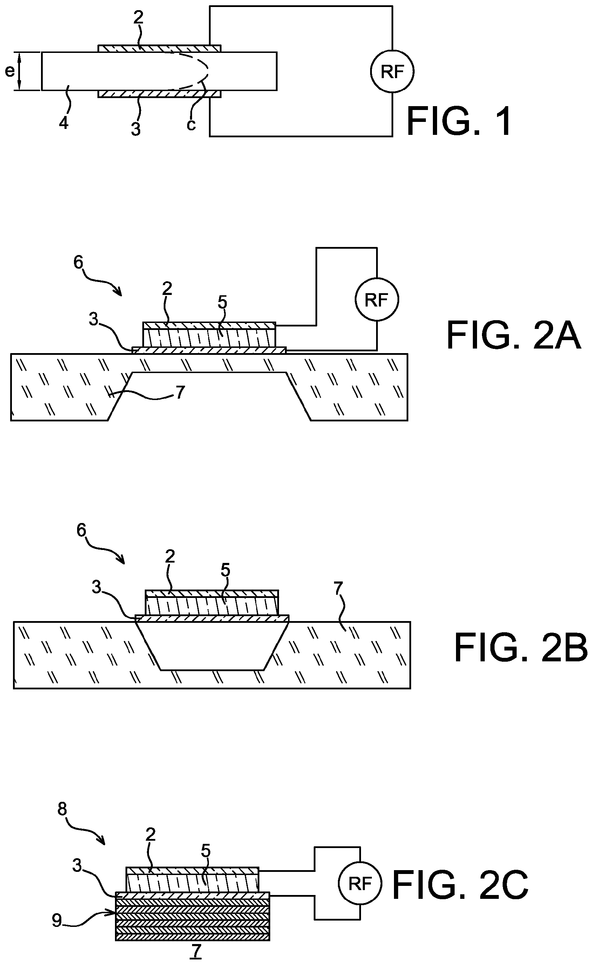

En particulier, dès les années 1920, des résonateurs basés sur la mise en vibration d'une lame d'un matériau piézoélectrique ont été réalisés : tel que schématisé en figure 1, ce type de composant 1 comprend deux électrodes 2, 3 en regard enserrant une plaque de matériau piézoélectrique 4. L'application d'un champ radiofréquence RF aux bornes du dipôle 2, 3 ainsi constitué engendre, par effet piézoélectrique inverse, une déformation de la plaque 4 selon les couplages permis par l'orientation cristalline de son matériau constitutif. Un phénomène de résonance se produit lorsque la fréquence F d'excitation RF correspond à la vitesse V de phase du déplacement engendré divisée par deux fois l'épaisseur e de la plaque 4 (F = V/2e) : les déplacements en surface de la plaque 4 sont alors d'amplitude maximale, alors que les contraintes C atteignent leur maximum en son centre. Le quartz s'est révélé le matériau privilégié de ce type d'applications compte tenu de ses propriétés thermo-élastiques (coefficients de qualité mécanique élevés, existence d'orientations compensées des effets de température, *etc.*).

Cependant, pour gagner en fréquence, il devient nécessaire d'amincir les matériaux massifs usuels jusqu'à des épaisseurs e rendant toute application industrielle (où l'épaisseur minimum des plaques est de l'ordre de 30 $\mu$m) hasardeuse : pour un résonateur 1 fonctionnant sur mode fondamental à 300 MHz par l'intermédiaire d'une onde de cisaillement à 3500 m·s$^{-1}$, l'épaisseur e de la plaque 4 d'une coupe AT du quartz devrait être de l'ordre de 6 $\mu$m. Même avec l'utilisation d'harmoniques supérieures et d'autres coupes de quartz (comme la coupe BT permettant d'utiliser une onde se propageant à 5100 m·s$^{-1}$), une fréquence de 1 GHz représente la limite pratique de mise en oeuvre des résonateurs classiques à ondes de volume.

Ces dispositifs ont ainsi été supplantés, pour les applications de traitement du signal radiofréquence, par des composants passifs à ondes de surface (SAW : « Surface Acoustic Waves ») qui se sont révélés capables d'atteindre des gammes de fréquence dépassant le gigahertz, et ont connu de nombreuses applications comme l'interrogation à distance de capteurs passifs. Cependant, de telles structures résonantes à ondes de surface impliquent un encombrement certain, lié à la longueur d'onde acoustique et à leur configuration même, qui réclame une longueur minimum pour réaliser leur fonction spectrale.

Par ailleurs, la réalisation de couches minces piézoélectriques sur des substrats non piézoélectriques a été développée, et il est apparu possible d'exciter, au sein de films piézoélectriques, des ondes de volume, souvent à polarisation longitudinale, présentant simultanément de très hautes vitesses de propagation et un couplage piézoélectrique élevé (quelques %). Différents résonateurs à ondes de volume à films minces piézoélectriques 5 ont été mis au point : les résonateurs 6 à film mince sur substrat 7 (TFR : « Thin Film Resonator »), usinés en surface ou dans le volume (FBAR : « Film Bulk Acoustic Resonator », HBAR : « Harmonie Bulk Acoustic Resonator »), sont respectivement illustrés en figures 2A et 2B, et le résonateur 8 à miroir de Bragg 9 (SMR : « Solidely Mounted Resonator ») est illustré en figure 2C.

La principale difficulté technologique de réalisation d'un tel composant réside dans l'élimination ou l'amincissement local du substrat 7 situé sur la face arrière de la couche 5 afin de permettre à la vibration de s'établir librement : le substrat 7 subsistant sous la membrane piézoélectrique 5 apparaît comme susceptible d'engendrer des modes parasites. Il a ainsi été envisagé une solution composite permettant de coupler les avantages liés à l'utilisation d'une couche piézoélectrique 5 dont la nature est dissociée de celle du substrat 7, basée sur le principe de fonctionnement des lignes à retard à ondes de volume.

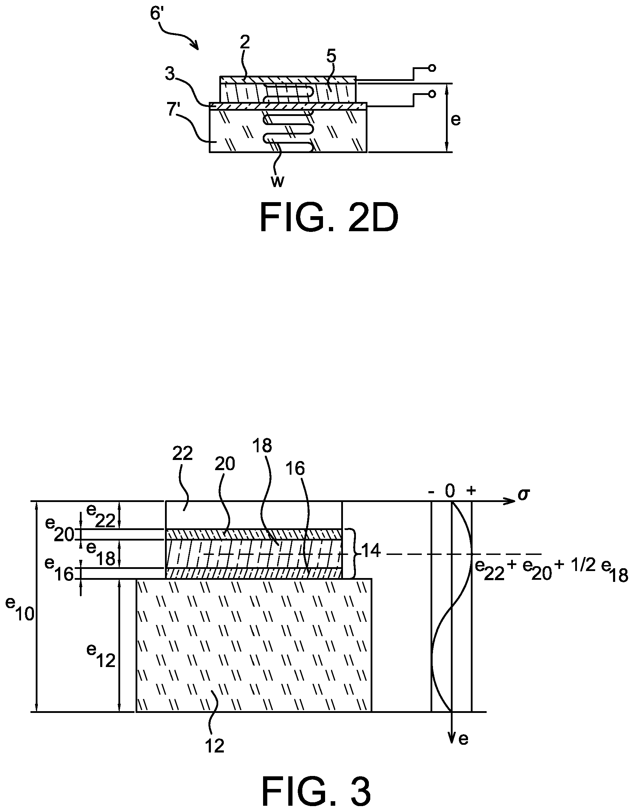

Les lignes à retard les plus simples sont constituées par une structure composite transducteur piézoélectrique/matériau de propagation/transducteur piézoélectrique au sein de laquelle se propagent des ondes de volume W : le retard dépend de la longueur du chemin acoustique à parcourir. Une version simplifiée de cette structure (figure 2D) confond les transducteurs d'entrée et de sortie, et le trajet acoustique implique une réflexion sur une surface plane. Cette dernière structure 6', dite structure résonante composite, présente une multiplicité de modes correspondant aux harmoniques possibles du mode fondamental de la structure 6', dont la fréquence est toujours donnée par la relation F = V/2e avec e l'épaisseur effective de la plaque composite couche mince 5 / substrat 7' et V la vitesse équivalente du mode, qui dépend principalement des propriétés élastiques du substrat 7' (de préférence un monocristal) légèrement perturbées par le film 5 ; la polarisation est fixée par les couplages piézoélectriques du film 5. Le choix des épaisseurs des différentes couches, et notamment de la lame monocristalline 7', est effectué pour que l'une des résonances harmoniques de rang N de l'empilement corresponde à la fréquence recherchée de fonctionnement $F_0$ du résonateur 6' ; de plus, un dimensionnement de la structure permet d'obtenir un écart spectral entre deux résonances très supérieur à la bande de fréquence de travail (par exemple 1,8 MHz pour la bande centrée en 433,92 MHz). Ainsi, la résonance choisie peut être sélectionnée avec précision.

Pour une structure composite 6' selon la figure 2D, il apparaît nécessaire de disposer d'un coefficient de couplage optimal pour limiter les pertes d'insertion. Or, dans les cas d'une couche 5 d'AIN déposée sur un substrat en silicium 7', même s'il est possible d'optimiser la valeur du coefficient de couplage $K_S^2$ en faisant varier l'épaisseur du substrat 7', l'obtention d'une valeur de 1 ‰, coefficient de l'onde de Rayleigh sur le quartz qui est la limite inférieure pour un fonctionnement effectif du résonateur 6', est subordonnée à l'utilisation du mode fondamental. Un si faible coefficient de couplage est juste compatible avec la plupart des applications envisagées de mesure à distance.

Il a certes été proposé (Shih-Yung Pao et coll. : « Analysis and experiment of HBAR frequency spectra and application to characterize the piezoelectric thin film and to HBAR design », Proceedings of the IEEE International Frequency Control Symposium 2002 ; 8A-5) d'augmenter l'épaisseur de l'électrode supérieure 2 pour remédier à ce problème ; cette optimisation du facteur de couplage Ks2 se fait cependant aux détriments de la valeur du coefficient de surtension de la structure résonante 6', et donc de sa possible utilisation.

Le document US 4 642 508 montre une structure résonante acoustique avec un support surmonté d'un transducteur piézoélectrique formé de deux électrodes prenant en sandwich une couche de matériau piézoélectrique.

L'ensemble est surmonté d'un film diélectrique stable chimiquement pour compenser les caractéristiques de température du matériau piézoélectrique.

Le document us 6 087 198 divulgue un résonateur film mince avec un résonateur piézoélectrique supporté par substrat associé à réflecteur acoustique de type miroir de Bragg.

## EXPOSÉ DE L'INVENTION

L'invention se propose de pallier certains des problèmes mentionnés plus haut concernant les structures résonantes.

En particulier, l'invention se rapporte à un résonateur permettant de surmonter simultanément les difficultés rencontrées à haute fréquence avec la solution à ondes de volume, l'impossibilité de travailler en basse fréquence sur des structures FBAR simples, et l'absence d'un niveau de couplage suffisant lorsque l'on travaille sur des structures composites.

Pour un résonateur à ondes de volume, il a été constaté que le couplage entre l'énergie électrique et le milieu piézoélectrique est maximal lorsque la contrainte maximale s'applique au milieu de la couche piézoélectrique. Pour limiter les effets néfastes sur la surtension liés à l'utilisation d'électrodes supérieures de forte masse, l'invention propose ainsi d'utiliser un matériau qui vient recouvrir l'électrode supérieure de façon à déplacer, par effet de propagation, la position du ventre de dilatation au sein de la couche piézoélectrique.

Sous un de ses aspects, l'invention concerne donc une structure résonante, telle que définit par la revendication indépendante 1, comprenant un transducteur piézoélectrique qui comprend deux électrodes entourant une couche de matériau piézoélectrique, avantageusement sous forme de film mince. L'une des deux électrodes est mise en place sur un support, et l'autre est revêtue d'une couche additionnelle dont l'épaisseur est déterminée en fonction de l'épaisseur du substrat et des paramètres de fonctionnement du résonateur, pour optimiser la densité acousto-électrique au sein de la couche piézoélectrique. L'épaisseur de la couche additionnelle permet de fait de déplacer le « ventre » de contrainte au sein de l'empilement, ce qui est différent du positionnement d'un miroir de Bragg qui, lui, permet une encapsulation.

Le support peut être un substrat, avantageusement sous forme de lame, ou un miroir de Bragg positionné sur un substrat ; la couche additionnelle peut elle aussi être recouverte par un miroir de Bragg. La structure résonante selon l'invention munie d'un miroir de Bragg peut avantageusement être enrobée, entièrement ou partiellement, dans une couche de protection, qui peut servir de boîtier ; au moins un miroir de Bragg est choisi pour que son coefficient de réflexion soit maximal au voisinage de la fréquence de résonance de la structure.

Le substrat peut être constitué de plusieurs matériaux, qui avantageusement possèdent des facteurs de qualité mécanique et diélectrique tels que le produit QF de la structure résonante dépasse 3 ou $5 \cdot 10^{12}$ ; de préférence, il s'agit de quartz monocristallin, mais de nombreux matériaux sont possibles (verre, silice, $La_3Ga_5SiO_{14}$, $La_3Ga_{5,5}Nb_{0,5}O_{14}$, $La_3Ga_{5,5}Ta_{0,5}O_{14}$, $GaPO_4$, saphir, $LiNbO_3$, $KNbO_3$, $LiTaO_3$, C, SiC,...). Sous le mode de réalisation préféré, le substrat est tel que le résonateur selon l'invention est un HBAR, c'est-à-dire que l'épaisseur totale active de la structure résonante est supérieure à une longueur d'onde et donc que l'énergie acoustique n'est pas confinée dans la couche piézoélectrique mais est aussi présente dans le substrat.

La couche piézoélectrique est avantageusement composée de nitrure d'aluminium, qui peut être déposée par pulvérisation cathodique par exemple ; si la couche piézoélectrique est composée d'un monocristal, il peut être rapporté par collage moléculaire suivi d'un amincissement. Les électrodes sont avantageusement des couches métalliques déposées ou intégrées sur leur support, à savoir substrat, miroir de Bragg ou couche piézoélectrique. La couche additionnelle peut être piézoélectrique ou non ; de préférence, elle est mise en place par croissance épitaxiale d'un matériau monocristallin, mais elle peut également comprendre un matériau comme celui utilisé pour le substrat.

La structure résonante selon l'invention, selon son utilisation, peut être associée à une autre structure de nature similaire, à un capteur capacitif, et/ou à une antenne pour réaliser une fonction de transpondeur. Le choix des caractéristiques, en particulier des matériaux, impédances et dimensions, de chaque structure résonante associée peut permettre une mesure différentielle de la température.

L'invention se rapporte sous un autre aspect à un procédé pour fabriquer de telles structures résonantes tel que définit par la revendication indépendante 16.

Grâce à l'invention, il est possible d'augmenter considérablement les performances de couplage, notamment d'un facteur 5 à 10, par exemple en faisant passer le coefficient de couplage à 0,001 pour un résonateur HBAR composé d'un substrat de silicium et un film piézoélectrique en nitrure d'aluminium, alors que les solutions standards donnent $K_S^2 = 0{,}0002$.

## BRÈVE DESCRIPTION DES DESSINS

Les caractéristiques et avantages de l'invention seront mieux compris à la lecture de la description qui va suivre et en référence aux dessins annexés, donnés à titre illustratif et nullement limitatifs.

La figure 1, déjà décrite, illustre le principe d'un résonateur classique à ondes de volume.
Les figures 2A, 2B, 2C et 2D, déjà décrites, schématisent différentes structures résonantes à film mince.
La figure 3 montre une structure composite selon l'invention, et la position en son sein de la variation d'amplitude des contraintes et déformations.
La figure 4 représente la variation du coefficient de couplage en fonction de l'épaisseur de la couche piézoélectrique.
La figure 5 montre une autre structure composite selon l'invention.
La figure 6 illustre l'utilisation d'une structure selon l'invention en tant que transpondeur.

## EXPOSÉ DÉTAILLÉ DE MODES DE RÉALISATION PARTICULIERS

Pour une structure résonante hybride comprenant un film piézoélectrique, le couplage entre l'énergie électrique et le milieu piézoélectrique est maximal si le maximum de contrainte est appliqué au milieu de la couche piézoélectrique. De fait, le couplage électromécanique, les effets de température et de contraintes ainsi que l'isolation acoustique du résonateur sont des phénomènes non couplés au premier ordre, et à ce titre considérés généralement comme indépendants : la relation entre de tels phénomènes n'est pas triviale.

Un épaississement de la couche supérieure permet ainsi de déplacer cette contrainte. En particulier, dans les structures HBAR, cet effet n'est pas naturel puisque l'énergie y est distribuée dans la couche piézoélectrique 5 et le substrat 7.

Par ailleurs, pour éviter de se trouver confronté à la dégradation importante du coefficient de surtension de la structure résonante, il importe que l'énergie élastique puisse se propager au sein de la couche rapportée sur l'électrode.

Pour un dispositif selon l'invention, un diagramme, illustré en figure 3, montre ainsi l'évolution de l'intensité de la valeur de la contrainte de déformation $\sigma$ au sein (et en regard) de chaque couche du dispositif 10, dans le cas optimal où un ventre de contrainte (maximum d'intensité - en unité arbitraire) est positionné au centre de la couche piézoélectrique.

Tel qu'illustré sur la figure 3, un résonateur 10 selon l'invention comprend donc une lame 12 d'un matériau faisant office de substrat. L'amincissement du substrat 12 pour le mettre à épaisseur peut être réalisé préalablement ou au cours du procédé de fabrication du résonateur 10 ; il est également possible de modifier l'épaisseur du substrat 12 une fois le résonateur 10 fabriqué, par exemple en mettant à profit l'opération pour réaliser un ajustage de la fréquence de résonance du dispositif 10. Selon l'invention, les épaisseurs sont reliées entre elles par un calcul détaillé plus loin, de sorte que l'épaisseur $e_{12}$ de la lame faisant office de substrat 12 est optimisée en fonction des caractéristiques de l'ensemble des couches rapportées et des paramètres de fonctionnement de la structure résonante 10 (mode harmonique N, fréquence $F_0$). Avantageusement, le substrat 12 est fabriqué dans un matériau possédant des facteurs de qualité mécanique et diélectrique les plus élevés possibles, permettant d'atteindre ainsi un produit facteur de qualité $\times$ fréquence de résonance (QF) du mode utile supérieur à $3 \cdot 10^{12}$, par exemple un coefficient de qualité de la résonance du mode utile supérieur à 8000 au voisinage de 400 MHz. A titre d'exemple, le matériau peut être choisi parmi : le quartz cristallin ou monocristallin, le verre ou la silice amorphe, la langasite $La_3Ga_5SiO_{14}$ et ses variantes (langanite $La_3Ga_{5,5}Nb_{0,5}O_{14}$, langatate $La_3Ga_{5,5}Ta_{0,5}O_{14}$, etc.), le phosphate de gallium, le saphir, le niobate de lithium, le tantalate de lithium, le carbone diamant, le carbure de silicium,...

Sur la lame de substrat 12 est disposé un transducteur piézoélectrique 14. Le transducteur 14 comprend une première électrode 16, déposée à la surface de la lame 12 ; avantageusement, l'épaisseur $e_{16}$ de la couche composant la première électrode 16 est inférieure à $\lambda_{16}/20$, avec $\lambda_{16}$ la longueur d'onde de l'onde acoustique se propageant à l'intérieur de la couche. La première électrode est constituée par un matériau de préférence bon conducteur électrique afin de limiter les pertes ohmiques ; avantageusement il s'agit d'un métal (Al, Mo, Ni, Ag, Pt, Au, W, Cu,...), choisi de sorte qu'il est susceptible, si possible, de se déposer de façon orientée à la surface du substrat 12. De préférence, l'électrode 16 est déposée par épitaxie de façon à permettre la réalisation par épitaxie également de la couche piézoélectrique 18, et à garantir ainsi son orientation.

En effet, le transducteur 14 comprend une couche de matériau piézoélectrique 18 mise en place au dessus de la première électrode 16 ; le procédé de mise en place, qui dépend de la nature du matériau piézoélectrique, est choisi pour minimiser les défauts de texture de la couche 18 qui constituent des sources de dissipation néfastes au confinement de l'énergie acousto-électrique dans l'épaisseur de la structure 10. On peut ainsi déposer du niobate de lithium, du niobate de potassium, du nitrure d'aluminium, de l'oxyde de zinc, et d'autres matériaux piézoélectriques, par pulvérisation cathodique. Plus généralement, la couche piézoélectrique peut être déposée par pulvérisation cathodique, ou laser, par dépôt chimique en phase vapeur par organométallique (MOCVD : « Métal Organic Chemical Vapor Deposition ») ou par épitaxie par jet moléculaire (MBE : « Molecular Beam Epitaxy »), ou obtenue par croissance épitaxiale. Une méthode particulièrement intéressante de dépôt de films piézoélectriques 18 repose sur le collage moléculaire d'une couche épaisse sur l'ensemble épais substrat 12 - première électrode 16, suivi de l'érosion et du polissage du film 18 avec mise à l'épaisseur requise : il est envisageable d'utiliser ainsi n'importe quel monocristal orienté pour l'excitation sur n'importe quel monocristal orienté pour la propagation.

De préférence, les caractéristiques du matériau piézoélectrique 18 permettent d'atteindre, pour le résonateur composite 10 dans le mode de fonctionnement retenu, un couplage électromécanique supérieur ou égal à celui des ondes de surface sur quartz en coupes (ST, X), soit 1 ‰. Avantageusement, des matériaux à fort coefficient de couplage sont utilisés, comme le nitrure d'aluminium (AlN) ou l'oxyde de zinc (ZnO) qui sont raisonnablement simples à mettre en oeuvre par différentes méthodes, en particulier sur silicium.

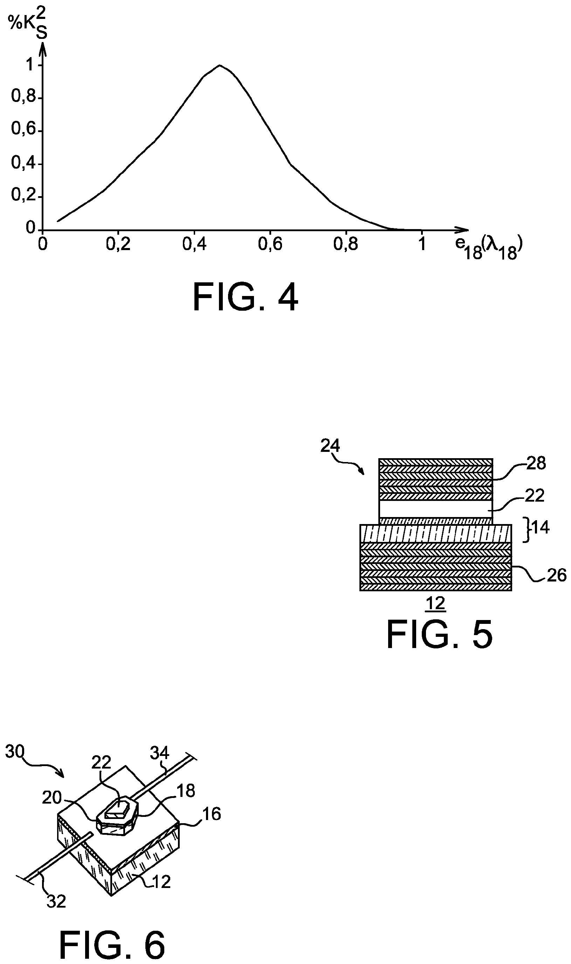

Pour une longueur d'onde acoustique $\lambda_{18}$ au sein de la couche piézoélectrique 18, la variation du coefficient de couplage diélectrique $K_S^2$ au sein de la couche 18 en fonction de l'épaisseur relative de la couche piézoélectrique $e_{18}$, exprimée ici en fraction de la longueur d'onde $\lambda_{18}$, est illustrée en figure 4 : le couplage optimal est obtenu pour une épaisseur de la couche $e_{18}$ égale à $\lambda_{18}/2$. Un optimum local est également obtenu pour un multiple impair de $\lambda_{18}/2$, c'est-à-dire que l'épaisseur $e_{18}$ est avantageusement sous la forme :  $e_{18} = \left(2n' + 1\right) \cdot \dfrac{\lambda_{18}}{2}$ , avec n' entier naturel.

L'épaisseur $e_{18}$ de la couche piézoélectrique 18 permettant de conserver un coefficient de couplage $K_S^2$ utile supérieur ou égal à 20 % de la valeur maximale sera comprise entre $0{,}15 \cdot \lambda_{18} \leq e_{18} \leq 0{,}75 \cdot \lambda_{18}$. Le choix de l'épaisseur varie en fonction de la nature de la couche piézoélectrique 18, des applications, et des limites technologiques de réalisation ; pour certaines applications, il est par ailleurs possible d'utiliser des valeurs plus faibles que l'épaisseur optimale pour limiter le couplage ou pour permettre une réalisation technologique non problématique de la couche.

Pour une fréquence de fonctionnement donnée $F_0$, la longueur d'onde $\lambda$ est reliée aux propriétés du matériau en fonction de la vitesse de propagation V de l'onde dans ce matériau selon la relation  $\lambda = \dfrac{V}{F_0}$ ;  suivant le choix du mode de fonctionnement du dispositif 10, la vitesse V peut désigner la vitesse de compression ou la vitesse de cisaillement dans le matériau.

Dans le cas présent, on obtient donc :  $e_{18} = \left(2n' + 1\right) \cdot \dfrac{V_{18}}{2 \cdot F_0}$ ,  $e_{18}$ avec $V_{18}$ la vitesse de propagation de l'onde acoustique au sein de la couche piézoélectrique 18. A titre d'exemple, pour une couche piézoélectrique 18 de nitrure d'aluminium AlN fonctionnant sur un mode de compression, l'évolution de l'épaisseur $e_{18}$ de la couche permettant d'obtenir un couplage optimal en fonction de la fréquence de fonctionnement $F_0$ du dispositif 10 est la suivante :

| $F_0$ (MHz) | $e_{18}$ ($\mu$m) |
| --- | --- |
| 433 | 13 |
| 866 | 6,5 |
| 2450 | 2,3 |

A titre indicatif, si x est le facteur de réalisation en fonction du matériau et de sa filière de fabrication, comme

$$e_{18} = \left(n' + x\right) \cdot \frac{V_{18}}{F_0} \text{ ,} \quad \text{on essaie d'obtenir } n' = 0 \text{ et } x = 0,5.$$

Une contre électrode 20 est ensuite déposée à la surface du matériau piézoélectrique 18. Comme dans le cas de la première électrode 16, cette deuxième électrode 20 est constituée par un matériau de préférence bon conducteur électrique, avantageusement un métal susceptible de se déposer de façon orientée, ou mieux épitaxiée. De même, avantageusement, l'épaisseur $e_{20}$ de la couche d'électrode 20 est inférieure à $\lambda_{20}/20$, avec $\lambda_{20}$ la longueur d'onde de l'onde acoustique se propageant à l'intérieur du matériau de l'électrode 20.

La surface en regard des deux électrodes 16, 20 permet d'ajuster les paramètres d'impédance et de capacité statique, et donc la fréquence de résonance de la structure 10.

De préférence, la structure 10 selon l'invention est de type « HBAR », où l'énergie est répartie de façon à peu près homogène entre la couche piézoélectrique 18 et le substrat 12. Ces structures 10 sont caractérisées par une résonance sur harmonique de l'ensemble substrat 12 / couche piézoélectrique 18, avec une épaisseur totale active $e_{10}$ d'au moins une longueur d'onde. L'énergie acoustique n'est pas confinée dans la couche piézoélectrique 18, mais au contraire est largement présente dans le substrat 12. A l'inverse, dans une structure de type « FBAR », l'énergie acoustique est naturellement confinée dans la couche piézoélectrique 18, et la structure est caractérisée par une résonance en mode fondamental de la couche piézoélectrique 18 (une demi-longueur d'onde ou proche).

Cet empilement 12, 16, 18, 20 est complété, dans le cadre de l'invention, par une couche additionnelle 22 déposée à la surface de la contre électrode 20. Cet élément additionnel 22 est composé d'un ou plusieurs matériaux, choisis avec des facteurs de qualité mécanique et/ou diélectrique élevés, afin de limiter les pertes intrinsèques du dispositif 10. Avantageusement, selon la nature de la contre électrode 20, la couche 22 peut être réalisée par épitaxie, pour garantir ainsi son orientation.

La couche 22 selon l'invention permet de concentrer l'énergie acousto-électrique du mode utile dans la couche piézoélectrique 18 ; il s'agit, à la limite, d'un élément d'adaptation d'impédance globale du dispositif 10. En particulier, pour une structure résonante 10 de type HBAR, cette couche additionnelle 22 est telle que l'énergie n'est pas confinée dans la couche piézoélectrique 18 bien que significativement présente, en positionnant le ventre de contrainte dans cette couche 18.

L'épaisseur $e_{22}$ de la couche additionnelle 22 dépend donc des épaisseurs $e_{18}$ et $e_{12}$ de la couche piézoélectrique 18 et du substrat 12. Avantageusement, la croissance de la couche additionnelle 22 est telle que cette couche 22 présente une texture permettant d'obtenir des valeurs de surtension suffisantes pour limiter les pertes intrinsèques du dispositif 10.

Pour certaines applications particulières ne nécessitant pas un facteur de qualité Q élevé, cette couche 22 peut constituer l'électrode supérieure 20, dont l'épaisseur est alors déterminée de la même manière que celle de la couche additionnelle 22 (et non $e_{20,22} \leq \lambda_{20,22}/20$). Cependant, avantageusement, le matériau de la couche 22 est choisi parmi les matériaux utilisés pour réaliser le substrat 12, c'est-à-dire en particulier, et sans limitation, le quartz monocristallin, un verre ou de la silice amorphe, la langasite et ses variantes (langanite, langatate, etc.), le phosphate de gallium, le saphir, le niobate de lithium, le tantalate de lithium, le carbone diamant, le carbure de silicium,.... La couche additionnelle 22 peut ou non avoir des propriétés piézoélectriques ; elle peut aussi comprendre du nitrure d'aluminium ou du niobate de potassium.

Le choix des épaisseurs des différentes couches et notamment de la lame 12 est calculé pour que l'une des résonances harmoniques de rang N (N $\geq$ 1) de l'empilement 14, 22 corresponde à la fréquence $F_0$ de fonctionnement de la structure résonante 10.

Dans un mode de réalisation préféré, les éléments constitutifs sont choisis de sorte que la sensibilité à la contrainte soit la plus élevée possible, pour permettre, après intégration dans une structure déformable spécifique, la mesure des effets de contraintes induits par la déformation du corps au sein duquel elle se trouve.

Le mode de calcul de l'épaisseur de la couche supplémentaire 22 est identique à celui de la couche de substrat 12 : chacune dépend de l'épaisseur utilisée pour réaliser la couche piézoélectrique 18. Les épaisseurs $e_{12}$ et $e_{22}$ s'expriment en fonction de la longueur d'onde acoustique $\lambda_{12}$ et $\lambda_{22}$ se propageant dans la couche 12, 22 respective (la longueur d'onde $\lambda_{12}$, $\lambda_{22}$ étant liée à la vitesse de propagation en compression ou cisaillement $V_{12}$, $V_{22}$ de l'onde acoustique au sein du matériau respectif 12, 22 et à la fréquence de fonctionnement $F_0$).

Si, selon les contraintes de fabrication, les épaisseurs des couches métalliques destinées à la réalisation des électrodes 16, 20 sont telles que $e_{16} \leq \dfrac{V_{16}}{20 \cdot F_0}$ et $e_{22} \approx e_{16} \leq \dfrac{V_{22}}{20 \cdot F_0}$ , il est possible de les négliger, et l'épaisseur de la structure 10 selon l'invention est donnée par $e_{10} = e_{12} + e_{18} + e_{22}$.

En considérant une harmonique de fonctionnement N de la structure pour une fréquence $F_0$, on peut exprimer l'épaisseur de chacune des couches en fonction de la vitesse de propagation du son dans leur matériau :

$$e_{12} = \left[ n \cdot \frac{V_{12}}{2} + \left(1 - 2x'\right) \cdot \frac{V_{12}}{4} \right] \cdot \frac{1}{F_0}$$

$$e_{18} = \left(n' + x\right) \cdot \frac{V_{18}}{F_0}$$

$$e_{22} = \left[ n'' \cdot \frac{V_{22}}{2} + \left(1 - 2x'\right) \cdot \frac{V_{22}}{4} \right] \cdot \frac{1}{F_0} \,,$$

et donc

$$e_{10} = \left\{ \left[ n \cdot \frac{V_{12}}{2} + \left(1 - 2x'\right)\frac{V_{12}}{4} \right] + \left(n' + x\right) \cdot V_{18} + \left[ n'' \cdot \frac{V_{22}}{2} + \left(1 - 2x'\right)\frac{V_{22}}{4} \right] \right\} \cdot \frac{1}{F_0}$$

avec $N = n + 2n' + n''$, $n$, $n'$ et $n''$ entiers naturels (et de préférence $n' = 0$), $x$ nombre réel déterminé en fonction des possibilités technologiques de la filière de fabrication, et optimisé en fonction du matériau ($0 \le x \le 1$, de préférence $x = 0{,}5$) et $x' = x \pm 20\,\%$ en fonction des contraintes de fabrication, c'est-à-dire $0 \le x' \le 1{,}2$ ajustant la tolérance par rapport à $x$ optimisé.

En particulier, en prenant comme exemple le cas d'une structure 10 avec un film 18 de nitrure d'aluminium sur un substrat 12 en silicium, sur l'électrode supérieure 20 de laquelle a été rapportée une lame 22 de silicium d'épaisseur égale à celle utilisée pour le substrat 12 (configuration symétrique), une amélioration d'un facteur 5 à 10 du coefficient de couplage $K_S^2$ par rapport aux valeurs sans lame supérieure 22 a été constatée.

Par exemple, pour un HBAR 10 constitué d'un substrat 12 en silicium et d'une couche mince 18 piézoélectrique d'AlN, le coefficient de couplage des solutions standards est d'environ $K_S^2 = 0{,}0002$. Avec une couche additionnelle 22 au sens de l'invention, il passe à 0,001, soit 5 fois mieux, atteignant ainsi le coefficient de couplage d'un résonateur à Quartz.

De fait, on ne peut pas considérer l'addition d'une couche additionnelle comme évidente pour l'homme de l'art puisqu'aucune des réalisations de HBAR publiées ne comporte cette couche additionnelle qui permet de déplacer le ventre de contrainte.

Certes, des couches additionnelles ont été décrites, mais à des fins différentes et pour des structures FBAR. En particulier, dans le document US 4 642 508, la couche additionnelle a vocation à diminuer la sensibilité thermique du dispositif, ainsi qu'à réduire l'état de contraintes du dispositif final en relaxant celles-ci par effets de compensation. La couche déposée présente idéalement un état de contraintes égal et opposé à celui du film piézoélectrique et de ses électrodes associées, et son épaisseur n'est pas suffisante pour déplacer le « ventre » de contrainte dans l'empilement. De même, le placement simple de miroirs de Bragg sur une structure FBAR, tel que présenté dans US 6 087 198 pour permettre une encapsulation, est étudié pour maintenir l'énergie acoustique confinée dans la couche piézoélectrique.

Par ailleurs, et par analogie avec les structures de type TFR de la figure 2, il est possible de munir le résonateur 10 selon l'invention d'un miroir de Bragg au moins. Une structure résonante 24, illustrée en figure 5, comprend ainsi un miroir de Bragg 26 sur la face inférieure du transducteur 14, entre un substrat 12 et la première électrode 16, et/ou un miroir de Bragg 28 sur la face supérieure de la couche supplémentaire 22 destinée à concentrer l'énergie (avec cependant $e_{10} = e_{12} + e_{18} + e_{22}$ par exemple).

Tel qu'il est usuel, chaque miroir de Bragg 26, 28 est composé d'une alternance de couches de matériaux d'indices de réflexion différents dont l'épaisseur est un multiple impair de $\lambda/4$, avec $\lambda$ longueur d'onde de l'onde qui se propage à l'intérieur du réseau 26, 28 : les réflexions successives sur les diverses couches créent l'effet de miroir ; par exemple, les empilements sont constitués par l'alternance de couches de Si et de $Si_xN_y$. Le coefficient de réflexion de chaque miroir 26, 28 est avantageusement choisi pour être maximal au voisinage de la fréquence de résonance de la structure 24.

La structure des couches utilisées pour réaliser chaque miroir 26, 28 est choisie pour réaliser une bande d'arrêt (c'est-à-dire le domaine spectral dans lequel le miroir accomplit sa fonction de réflexion totale des ondes) centrée autour d'une résonance harmonique, elle-même choisie pour ses qualités propres de couplage, de coefficient de qualité, de sensibilité thermique, *etc.* Il peut également être intéressant, afin d'améliorer la pureté spectrale du résonateur 24, de réaliser une bande d'arrêt d'un miroir 26 de façon à ce que la largeur de bande soit inférieure à l'écart entre deux harmoniques de la structure résonante 24. Selon un mode de réalisation préféré, un absorbant acoustique, par exemple une couche de matériau organique, comme un polymère, notamment à base de résine époxy, est déposé à la surface d'au moins un miroir de Bragg 26, 28, ce qui permet d'éliminer la contribution des modes non réfléchis par le miroir à la réponse électrique du résonateur 24.

Dans le cas où l'utilisation d'un double miroir 26, 28 s'avérerait utile, il est possible de jouer sur la structure respective de chacun des miroirs de façon à ce que leur réponse spectrale soit légèrement décalée : la fonction de filtrage est ainsi élargie par rapport à une configuration à un seul miroir ou à deux miroirs symétriques. Avantageusement, le miroir avant 28 est décalé de sorte que la fréquence de résonance $F_0$ choisie soit dans la partie basse de la bande d'arrêt et le miroir arrière 26 est tel que la fréquence de résonance $F_0$ se situe dans la partie haute de la bande d'arrêt, ou réciproquement.

Le résonateur 10, 24 selon l'invention fonctionne avantageusement dans une gamme de fréquence comprise entre 250 MHz et 6000 MHz et plus particulièrement dans les bandes réservées, selon les pays, aux applications radio utilisant des composants à courte portée (« *Short Range Devices* »), qui sont centrées autour des valeurs suivantes : 300 MHz, 433,92 MHz, 866 MHz, 915 MHz, 2441,75 MHz, 5250 MHz et 5825 MHz, ainsi que dans les bandes utiles respectives associées : fréquences inférieures à, ou centrées sur, 1,74 MHz, 8 MHz, 26 MHz, 83,5 MHz, 200 MHz.

En particulier, le résonateur 10, 24 selon l'invention peut être utilisé de façon passive, par exemple : comme transpondeur simple interrogeable à distance ; ou comme transpondeur associé à un autre dispositif tel un capteur pour faire varier sa fréquence de résonance ; ou comme capteur convertissant une grandeur physique en une variation de fréquence, ce capteur pouvant être interrogeable à distance en utilisant la fonction de transpondeur intrinsèque au dispositif ; ou comme transpondeur associé à un moyen de moduler l'information de façon à réaliser un dispositif d'identification ; ou comme filtre de bande en associant en parallèle ou en série plusieurs structures résonantes. Par exemple, si le produit QF d'un ensemble de deux structures résonantes est supérieur ou égal à $5\cdot10^{12}$, l'ensemble peut être utilisé pour stabiliser un circuit oscillant. Le résonateur peut également être utilisé en association avec une batterie ou une téléalimentation comme source de fréquence.

Dans un mode de réalisation préféré, le résonateur selon l'invention peut être utilisé comme transpondeur 30, tel qu'illustré sur la figure 6. Un résonateur 10 est muni d'une antenne, ici à deux brins 32, 34, qui lui est raccordée : il est alors possible d'exciter la résonance électrique de la structure 10 en la plaçant dans le champ d'un émetteur fonctionnant dans la gamme de fréquences correspondante. Après excitation, la fréquence propre de la structure 12, 16, 18, 20, 22 sera réémise et pourra être analysée en utilisant un dispositif approprié. Il est ainsi possible de réaliser un transpondeur 30 dont le signal est asservi à l'état de la structure au moment de la réception.

Un tel transpondeur 30 peut être associé à un autre résonateur 10, 24 selon l'invention. Dans ce cas, avantageusement, l'écart entre les impédances des structures résonantes est minimisé afin de permettre leur interrogation à distance tout en limitant le différentiel de pertes - dans la pratique, il serait souhaitable que cet écart n'excède pas 10 % ; ainsi, la réponse est homogène entre les différents résonateurs.

Dans une autre utilisation préférée, la structure résonante 10, 24 selon l'invention est réalisée en utilisant un ensemble de matériaux qui accroissent sa sensibilité aux variations de température. Par exemple, on utilise de préférence des matériaux dont les coefficients de variation de la fréquence en fonction de la température (CFT) sont de mêmes signes, de façon à cumuler les effets, comme par exemple le niobate de lithium et le silicium, tous deux à CFT négatif.

Dans un autre cas de figure, pour limiter la sensibilité aux variations de fréquence, par exemple lorsque la bande de fréquence disponible pour l'interrogation est faible, deux matériaux dont les CTF sont contra variants, comme AlN et Si, peuvent être utilisés. Ici, la fréquence de résonance de l'ensemble de la structure 10 varie alors en fonction de la température, et il est possible d'utiliser la fonction de transpondeur 30 par exemple pour suivre directement l'évolution des variations de température.

Avantageusement, deux structures résonantes 10 sont utilisées conjointement de façon à ce que les fréquences des structures résonantes présentent des dérives opposées en fonction de la température, ce qui permet de doubler la sensibilité l'ensemble ainsi créé. En particulier, la sensibilité de la mesure électrique peut être optimisée en plaçant le résonateur à dérive thermique positive de la fréquence en entrée de la bande de fréquence autorisée, et celui à dérive thermique négative de la fréquence en sortie de ladite bande. Pour chaque résonateur séparément, on détermine l'écart entre sa fréquence de base et sa fréquence courante, et la somme des écarts mesurés pour chaque résonateur pour une même variation de température équivaut à une dérive thermique double de la valeur unitaire.

Inversement, si l'ensemble des matériaux choisis est tel que la sensibilité en température de la fréquence de résonance utile (dans la bande d'interrogation choisie) est la plus faible possible, la structure résonante peut ensuite être intégrée dans une structure mécanique déformable spécifique pour une mesure directe des effets de contrainte : la déformation de la structure mécanique entraîne une modification des propriétés acoustiques du résonateur, ce qui se traduit par une variation proportionnelle de sa (ses) fréquence(s) de résonance. La structure mécanique déformable peut être sous forme d'une barre rigide connectée à une membrane déformable dont l'épaisseur est ajustée pour optimiser la gamme de contraintes à mesurer et la résonance utile, représentative de l'information recherchée. Par exemple, dans un MEMS comprenant des jauges de contraintes, actives, associées à la membrane, ces jauges peuvent être remplacées par une structure selon l'invention afin de rendre le MEMS passif.

Il est possible par ailleurs de disposer plusieurs structures résonantes selon l'invention sur la même structure mécanique déformable, certaines étant disposées sur les parties sensibles à la contrainte et d'autres sur des parties non affectées par les contraintes ou sur une fibre neutre pour permettre de disposer d'une référence. La mesure de l'évolution de chaque fréquence par rapport à la référence fixe permet alors, d'une part d'isoler la dérive thermique résiduelle, et d'autre part de mesurer les effets de contraintes ; on peut également remonter au sens (signe) des effets à mesurer. De la même manière, pour s'affranchir de la mesure de température, il est possible d'utiliser une référence qui présente une sensibilité thermique égale à celle du corps d'épreuve, de telle sorte que l'écart fréquentiel entre résonateur de référence et résonateurs de mesure soit constant quelle que soit la température de travail.

Selon une autre utilisation, la structure résonante selon l'invention peut être couplée en série à un corps d'épreuve capacitif dont la valeur varie en fonction d'un paramètre physique à mesurer : la fréquence de résonance varie en fonction de la valeur de la capacité. L'ensemble des éléments constitutifs de la structure résonante est choisi de sorte que la sensibilité de la fréquence de résonance utile (dans la bande d'interrogation choisie) soit la plus faible possible, et la géométrie sélectionnée pour optimiser le couplage électromécanique afin d'effectuer une mesure de capacité par tirage de fréquence. L'interrogation se fait alors en utilisant la fonction de transpondeur de la structure résonante pour suivre directement l'évolution des variations de capacité. Avantageusement, la structure résonante a une capacité statique dont la valeur est proche de la capacité à caractériser.

Pour optimiser la sensibilité, la structure est conçue dans ce cas de façon à ce que la capacité statique du résonateur soit sensiblement égale à la capacité typique du corps d'épreuve capacitif. Pour améliorer encore la sensibilité, il est possible d'utiliser un ensemble d'au moins deux structures résonantes dont une seule est couplée au corps d'épreuve, l'autre étant utilisée comme référence. Il est également possible d'exploiter l'invention en couplant le corps d'épreuve capacitif en parallèle.

Quelle que soit l'utilisation envisagée pour l'invention, dans la configuration où la structure résonante est munie d'un ou plusieurs miroirs de Bragg, qui permettent de s'affranchir de la nécessité de disposer de surfaces libres, il est envisageable d'inclure une face ou l'ensemble de la structure selon l'invention dans un matériau d'enrobage ; selon les applications, cet enrobage pourra faire office de boîtier. Lorsque l'invention est utilisée comme transpondeur passif, qu'il soit partiel ou total, l'enrobage laisse passer ou inclut les fils d'antenne. Avantageusement, on pourra sélectionner un matériau d'enrobage qui permette de réaliser une fonction d'absorbant acoustique, par exemple un plastique ou tout polymère à base d'éléments organiques. L'absence de boîtier autre que l'enrobage et l'intégration de l'ensemble des fonctions d'antenne et d'absorbant au sein de l'enrobage permettent une forte réduction du coût final du transpondeur.

Un capteur selon l'invention peut donc être utilisé dans de nombreux domaines, en particulier dans toute application réclamant la mesure en environnement hostile de grandeurs physiques (pression, contraintes, température, accélération, etc.), que ce soit dans l'industrie pour le contrôle et la télémesure sur lignes de fabrication, ou la médecine, l'agro-alimentaire, ou encore la domotique en passant par le contrôle des flux de matière en transit, cette liste n'étant pas limitative.

En particulier, les résonateurs selon l'invention présentent : une surtension importante de façon à déterminer la fréquence et sa variation avec une précision suffisante ; des pertes d'insertion très faibles de façon à ne pas dissiper inutilement l'énergie reçue lors de la transduction ; une robustesse aux conditions environnementales hostiles dans lesquels ils sont susceptibles d'être soumis soit lors de leur mise en place, soit lors de leur exploitation, par exemple avec une température entre -50°C et 500°C.

**Revendications**

1. Structure résonante acoustique (10) du type HBAR comprenant un support (12, 26) et un transducteur piézoélectrique (14) qui comprend une première électrode conductrice (16) mise en place sur le support (12, 26) et une deuxième électrode (20) conductrice séparées par une couche de matériau piézoélectrique (18), l'épaisseur e18 de la couche de matériau piézoélectrique (18) étant donnée par la relation

$$e_{18} = (n'+x)\frac{V_{18}}{F_0}$$

avec n' entier naturel, de préférence n'=0, x nombre réel inférieur à 1 de préférence x=0,5, V18 vitesse de propagation de l'onde acoustique dans le matériau piézoélectrique et F0 fréquence de fonctionnement de la structure résonante (10), la structure résonante acoustique comprenant également une couche additionnelle (22) mise en place à la surface de la deuxième électrode (20) opposée à la couche piézoélectrique (18), l'épaisseur e22 de la couche additionnelle (22) étant donnée par la relation

$$e_{22} = \left[ n'' \frac{V_{22}}{2} + (1 - 2x') \frac{V_{22}}{4} \right] \frac{1}{F_0}$$

avec n" entier naturel, de préférence n"=1, V22 vitesse de propagation de l'onde acoustique dans la couche additionnelle (22), et x' = ± 20% de manière à optimiser la densité acousto-électrique au sein de la couche piézoélectrique (18), dans laquelle l'épaisseur e16 de la couche composant la première électrode (16) est inférieure à $\lambda16/20$, avec $\lambda16$ la longueur d'onde de l'onde acoustique se propageant à l'intérieur du matériau de la première électrode, dans laquelle l'épaisseur e20 de la couche composant la deuxième électrode (20) est inférieure à $\lambda20/20$, avec $\lambda20$ la longueur d'onde de l'onde acoustique se propageant à l'intérieur du matériau de la deuxième électrode (20).

2. Structure résonante selon la revendication 1, dans laquelle le support est sous forme de lame de substrat (12) constituée d'un matériau possédant des facteurs de qualité mécanique et diélectrique élevés afin d'atteindre un produit facteur de qualité x fréquence de résonance du mode utile (QF) supérieur à $3.10^{12}$, de préférence $5.10^{12}$.

3. Structure résonante selon la revendication 2, dans laquelle le substrat (12) comprend un matériau parmi ≃ le quartz cristallin, le verre ou la silice amorphe, la langasite et ses dérivés langanite et langatate, le phosphate de gallium, le saphir, le niobate de lithium, le tantalate de lithium, le carbone diamant, le carbure de silicium.

4. Structure résonante selon la revendication 2 ou 3, dans laquelle la lame de substrat (12) est constituée d'un monocristal de silicium.

5. Structure résonate selon l'une des revendications précédentes dans laquelle la couche de matériau piézoélectrique (18) est une couche mince de nitrure d'aluminium.

6. Structure résonante selon l'une des revendications 1 à 5 dans laquelle la couche additionnelle (22) comprend au moins l'un des matériaux suivants: du nitrure d'aluminium, du quartz cristallin, du verre ou de la silice amorphe, de la langasite et ses variantes langanite et langatate, du phosphate de gallium, du saphir, du niobate de lithium, du tantalate de lithium, du carbone diamant, du carbure de silicium, du niboate de potassium.

7. Structure résonante selon l'une des revendications 1 à 6, dans laquelle la couche additionnelle (22) comprend au moins un matériau monocristallin.

8. Structure résonante suivant l'une des revendications précédentes comprenant en outre, sur la couche additionnelle (22) et/ou comme support du transducteur (14), un miroir de Bragg (26, 28) qui est composé d'une alternance de couches de coefficients de réflexion différents et dont le coefficient de réflexion est maximale au voisinage de la fréquence de resonance de la structure acoustiques (24).

9. Structure résonante selon la revendication 8 comprenant en outre une couche d'enrobage de la structure au niveau du miroir de Bragg (26, 28) au moins.

10. Structure résonante selon l'une des revendications 1 à 9 dans laquelle les première et/ou deuxième électrodes (16, 20) sont des couches métalliques déposées ou intégrées sur, respectivement, le support (12, 26) et la couche de matériau piézoélectrique (18).

11. Structure acoustique résonante selon l'une des revendications 1 à 10 associée à une capacité variable.

12. Filtre de fréquence comprenant un ensemble de plusieurs structures résonantes selon l'une des revendications précédentes.

13. Transpondeur radiofréquence (30) comprenant une antenne (32, 34) associée à une structure résonante selon l'une des revendications 1 à 11 ou à un filtre selon la revendication 12.

14. Transpondeur selon la revendication 13 associé à au moins une seconde structure acoustique résonante selon l'une des revendications 1 à 11, les caractéristiques de chaque structure résonante permettant une mesure différentielle de température.

15. Transpondeur selon la revendication 13
associé à au moins une structure acoustique résonante suivant l'une des revendications 1 à 11, dans lequel les impédances des diverses structures acoustiques résonantes associées diffèrent de moins de 10%.

16. Procédé de fabrication d'une structure résonante du type HBAR comprenant la mise en place d'une couche de première électrode sur un support (12, 26), la mise en place d'un film piézoélectrique (18) sur la première électrode, la mise en place d'une deuxième électrode (20) sur le film piézoélectrique (18), et la mise en place d'une couche additionnelle (22) de matériau sur la deuxième électrode (20), l'épaisseur e18 de la couche de matériau piézoélectrique (18) étant donnée par la relation

$$e_{18} = (n'+x)\frac{V_{18}}{F_0}$$

avec n' entier naturel, de préférence n'=0, x nombre réel inférieur à 1 de préférence x=0,5, V18 vitesse de propagation de l'onde acoustique dans le matériau piézoélectrique et F0 fréquence de fonctionnement de la structure résonante (10), l'épaisseur e22 de la couche additionnelle (22) étant déterminée par la relation

$$e_{22} = \left[ n''\frac{V_{22}}{2} + (1-2x')\frac{V_{22}}{4} \right]\frac{1}{F_0}$$

avec n" entier naturel, de préférence n"=1, V22 vitesse de propagation de l'onde acoustique dans la couche additionnelle (22), et x' =x ± 20%, de manière à optimiser la densité acousto-électrique au sein de la couche piézoélectrique (18), dans laquelle l'épaisseur e16 de la couche composant la première électrode (16) est inférieure à λ16/20, avec λ16 la longueur d'onde de l'onde acoustique se propageant à l'intérieur du matériau de la première électrode (16), dans laquelle l'épaisseur e20 de la couche composant la deuxième électrode 20 est inférieure à $\lambda_{20}$/20, avec $\lambda_{20}$ la longueur d'onde de l'onde acoustique se propageant à l'intérieur du matériau de la deuxième électrode (20).

17. Procédé selon la revendication 16 dans lequel le film piézoélectrique (18) est reporté sur la première électrode (16) par collage moléculaire.

18. Procédé selon l'une des revendications 16 ou 17 dans lequel la première électrode (16) est déposée sur un support comprenant un substrat plan (12) en quartz monocristallin.

19. Procédé selon l'une des revendications 16 ou 17 dans lequel la première électrode (16) est déposée sur un support comprenant un miroir de Bragg (26).

20. Procédé selon l'une des revendications 16 à 19 comprenant la mise en place d'un miroir de Bragg (28) sur la couche additionnelle (22).

21. Procédé selon l'une des revendications 19 ou 20 comprenant l'enrobage du miroir de Bragg (26,28) au moins.

**Patentansprüche**

1. Akustische Resonanzstruktur (10) vom Typ HBAR, umfassend einen Träger (12, 26) und einen piezoelektrischen Wandler (14), der eine erste leitende Elektrode (16), die auf dem Träger (12, 26) angeordnet ist, und eine zweite leitende Elektrode (20) umfasst, die durch eine Schicht aus piezoelektrischem Material (18) getrennt sind, wobei die Dicke e18 der Schicht aus piezoelektrischem Material (18) durch die Gleichung

$$e_{18} = (n' + x)\frac{V_{18}}{F_0}$$

gegeben ist, in der *n'* eine natürliche ganze Zahl ist, bevorzugt *n'* = 0, x eine natürliche ganze Zahl kleiner 1 ist, bevorzugt x = 0,5, V18 die Ausbreitungsgeschwindigkeit der Schallwelle in dem piezoelektrischen Material ist und F0 die Betriebsfrequenz der Resonanzstruktur (10) ist, wobei die akustische Resonanzstruktur auch eine zusätzliche Schicht (22) umfasst, die an der Oberfläche der zweiten Elektrode (20) entgegengesetzt zur piezoelektrischen Schicht (18) angeordnet ist, wobei die Dicke e22 der zusätzlichen Schicht (22) durch die Gleichung

$$\mathrm{e}_{22} = \left[ n'' \frac{V_{22}}{2} + (1 - 2x')\frac{V_{22}}{4} \right]\frac{1}{F_0}$$

gegeben ist, in der *n″* eine natürliche ganze Zahl ist, bevorzugt *n″* = 1, V22 die die Ausbreitungsgeschwindigkeit der Schallwelle in der zusätzlichen Schicht (22) ist und *x'* = x $\pm$ 20 % ist, so dass die elektro-akustische Dichte in der piezoelektrischen Schicht (18) optimiert ist, wobei die Dicke e16 der Schicht, welche die erste Elektrode (16) bildet, kleiner als $\lambda$16/20 ist, wobei $\lambda$16 die Wellenlänge der Schallwelle ist, die sich im Innern des Material der ersten Elektrode ausbreitet, wobei die Dicke e20 der Schicht, welche die zweite Elektrode (20) bildet, kleiner als $\lambda$20/20 ist, wobei $\lambda$20 die Wellenlänge der Schallwelle ist, die sich im Innern des Materials der zweiten Elektrode (20) ausbreitet.

2. Resonanzstruktur nach Anspruch 1, bei welcher der Träger in Form eines Substratplättchens (12) vorliegt, das aus einem Material besteht, das hohe mechanische und dielektrische Gütefaktoren besitzt, um ein Produkt Gütefaktor x Resonanzfrequenz der Nutzmode (QF) größer als $3.10^{12}$, bevorzugt $5.10^{12}$ zu erreichen.

3. Resonanzstruktur nach Anspruch 2, bei der das Substrat (12) ein Material umfasst unter: kristallinem Quarz, Glas oder amorphem Siliciumoxid, Langasit und seinen Derivaten Langanit und Langatat, Galliumphosphat, Saphir, Lithiumniobat, Lithiumtantalat, Diamantkohlenstoff, Siliciumcarbid.

4. Resonanzstruktur nach Anspruch 2 oder 3, bei der das Substratplättchen (12) aus einem Silicium-Monokristall besteht.

5. Resonanzstruktur nach einem der vorhergehenden Ansprüche, bei der die Schicht aus piezoelektrischem Material (18) eine dünne Aluminiumnitridschicht ist.

6. Resonanzstruktur nach einem der Ansprüche 1 bis 5, bei der die zusätzliche Schicht (22) mindestens eines der folgenden Materialien umfasst: Aluminiumnitrid, kristalliner Quarz, Glas oder amorphes Siliciumoxid, Langasit und seine Varianten Langanit und Langatat, Galliumphosphat, Saphir, Lithiumniobat, Lithiumtantalat, Diamantkohlenstoff, Siliciumcarbid, Kaliumniobat.

7. Resonanzstruktur nach einem der Ansprüche 1 bis 6, bei der die zusätzliche Schicht (22) mindestens ein monokristallines Material umfasst.

8. Resonanzstruktur nach einem der vorhergehenden Ansprüche, umfassend ferner auf der zusätzlichen Schicht (22) und/oder als Träger des Wandlers (14) einen Bragg-Spiegel (26, 28), der aus einer Wechselfolge von Schichten mit unterschiedlichen Reflexionskoeffizienten besteht und dessen Reflexionskoeffizient in der Nähe der Resonanzfrequenz der akustischen Struktur (24) am größten ist.

9. Resonanzstruktur nach Anspruch 8, umfassend ferner eine Schicht zur Ummantelung der Struktur mindestens am Bragg-Spiegel (26, 28).

10. Resonanzstruktur nach einem der Ansprüche 1 bis 9, bei der die erste und/oder zweite Elektrode (16, 20) Metallschichten sind, die auf den Träger (12, 26) beziehungsweise die Schicht aus piezoelektrischem Material (18) aufgebracht oder integriert sind.

**11.** Akustische Resonanzstruktur nach einem der Ansprüche 1 bis 10, die einer variablen Kapazität zugeordnet ist.

**12.** Frequenzfilter, umfassend eine Anordnung aus mehreren Resonanzstrukturen nach einem der vorhergehenden Ansprüche.

**13.** Funkfrequenztransponder (30), umfassend eine Antenne (32, 34), die einer Resonanzstruktur nach einem der Ansprüche 1 bis 11 oder einem Filter nach Anspruch 12 zugeordnet ist.

**14.** Transponder nach Anspruch 13, der mindestens einer zweiten akustischen Resonanzstruktur nach einem der Ansprüche 1 bis 11 zugeordnet ist, wobei die Merkmale jeder Resonanzstruktur eine Differenz-Temperaturmessung ermöglichen.

**15.** Transponder nach Anspruch 13, der mindestens einer akustischen Resonanzstruktur nach einem der Ansprüche 1 bis 11 zugeordnet ist, wobei die Impedanzen der verschiedenen zugeordneten akustischen Resonanzstrukturen um weniger als 10 % abweichen.

**16.** Verfahren zur Herstellung einer Resonanzstruktur vom Typ HBAR, umfassend das Anordnen einer Schicht einer ersten Elektrode auf einem Träger (12, 26), das Anordnen eines piezoelektrischen Films (18) auf der ersten Elektrode, das Anordnen einer zweiten Elektrode (20) auf dem piezoelektrischen Film (18) und das Anordnen einer zusätzlichen Materialschicht (22) auf der zweiten Elektrode (20), wobei die Dicke e18 der Schicht aus piezoelektrischem Material (18) durch die Gleichung

$$e_{18} = (n' + x)\frac{V_{18}}{F_0}$$

gegeben ist, in der $n'$ eine natürliche ganze Zahl ist, bevorzugt $n' = 0$, x eine natürliche ganze Zahl kleiner 1 ist, bevorzugt x = 0,5, V18 die Ausbreitungsgeschwindigkeit der Schallwelle in dem piezoelektrischen Material ist und F0 die Betriebsfrequenz der Resonanzstruktur (10) ist, wobei die Dicke e22 der zusätzlichen Schicht (22) durch die Gleichung

$$e_{22} = \left[n'' \frac{V_{22}}{2} + (1 - 2x')\frac{V_{22}}{4}\right]\frac{1}{F_0}$$

gegeben ist, in der $n''$ eine natürliche ganze Zahl ist, bevorzugt $n'' = 1$, V22 die die Ausbreitungsgeschwindigkeit der Schallwelle in der zusätzlichen Schicht (22) ist und $x' = x \pm 20$ %, so dass die elektro-akustische Dichte in der piezoelektrischen Schicht (18) optimiert ist, wobei die Dicke e16 der Schicht, welche die erste Elektrode (16) bildet, kleiner als $\lambda 16/20$ ist, wobei $\lambda 16$ die Wellenlänge der Schallwelle ist, die sich im Innern des Material der ersten Elektrode (16) ausbreitet, wobei die Dicke e20 der Schicht, welche die zweite Elektrode 20 bildet, kleiner als $\lambda_{20}/20$ ist, wobei $\lambda_{20}$ die Wellenlänge der Schallwelle ist, die sich im Innern des Materials der zweiten Elektrode (20) ausbreitet.

**17.** Verfahren nach Anspruch 16, bei dem der piezoelektrische Film (18) durch molekulares Kleben auf die erste Elektrode (16) übertragen wird.

**18.** Verfahren nach einem der Ansprüche 16 oder 17, bei dem die erste Elektrode (16) auf ein Substrat aufgebracht wird, das ein ebenes Substrat (12) aus monokristallinem Quarz umfasst.

**19.** Verfahren nach einem der Ansprüche 16 oder 17, bei dem die erste Elektrode (16) auf einen Träger aufgebracht wird, der einen Bragg-Spiegel (26) umfasst.

**20.** Verfahren nach einem der Ansprüche 16 bis 19, umfassend das Anordnen eines Bragg-Spiegels (28) auf der zusätzlichen Schicht (22).

**21.** Verfahren nach einem der Ansprüche 19 oder 20, umfassend das Umhüllen mindestens des Bragg-Spiegels (26, 28).

**Claims**

1. Acoustic resonant structure (10) of the HBAR type comprising a carrier (12, 26) and a piezoelectric transducer (14) that comprises a first conductive electrode (16) placed on the carrier (12, 26) and a second conductive electrode (20), which electrodes are separated by a layer (18) of piezoelectric material, the thickness e18 of the layer (18) of piezoelectric material being given by the relationship

$$e_{18} = (n' + x)\frac{V_{18}}{F_0}$$

where n' is a natural integer and preferably n' = 0, x is a real number lower than 1 and preferably x = 0.5, V18 is the propagation speed of the acoustic wave in the piezoelectric material and F0 is the operating frequency of the resonant structure (10), the acoustic resonant structure also comprising an additional layer (22) placed on the surface of the second electrode (20) opposite the piezoelectric layer (18), the thickness e22 of the additional layer (22) being given by the relationship

$$e_{22} = \left[n''\frac{V_{22}}{2} + (1 - 2x')\frac{V_{22}}{4}\right]\frac{1}{F_0}$$

where n" is a natural integer and preferably n" = 1, V22 is the propagation speed of the acoustic wave in the additional layer (22), and x' = x $\pm$ 20% so as to optimize the acousto-electric density within the piezoelectric layer (18),
wherein the thickness e16 of the layer forming the first electrode (16) is smaller than $\lambda$16/20, where $\lambda$16 is the wavelength of the acoustic wave propagating inside the material of the first electrode,
wherein the thickness e20 of the layer forming the second electrode (20) is smaller than $\lambda$20/20, where $\lambda$20 is the wavelength of the acoustic wave propagating inside the material of the second electrode (20).

2. Resonant structure according to Claim 1, wherein the carrier takes the form of a substrate strip (12) made of a material possessing high dielectric and mechanical quality factors in order to achieve a product (QF) quality factor $\times$ resonant frequency of the useful mode higher than $3 \times 10^{12}$, and preferably $5 \times 10^{12}$.

3. Resonant structure according to Claim 2, wherein the substrate (12) comprises one material among: crystalline quartz, glass or amorphous silica, langasite and its derivatives langanite and langatate, gallium phosphate, sapphire, lithium niobate, lithium tantalate, diamond carbon, silicon carbide.

4. Resonant structure according to Claim 2 or 3, wherein the substrate strip (12) is made of single-crystal silicon.

5. Resonant structure according to one of the preceding claims, wherein the layer (18) of piezoelectric material is a thin layer of aluminium nitride.

6. Resonant structure according to one of Claims 1 to 5, wherein the additional layer (22) comprises at least one of the following materials: aluminium nitride, crystalline quartz, glass or amorphous silicon, langasite and its variants langanite and langatate, gallium phosphate, sapphire, lithium niobate, lithium tantalate, diamond carbon, silicon carbide, potassium niobate.

7. Resonant structure according to one of Claims 1 to 6, wherein the additional layer (22) comprises at least one single-crystal material.

8. Resonant structure according to one of the preceding claims, furthermore comprising, on the additional layer (22) and/or as carrier of the transducer (14), a Bragg mirror (26, 28) that is composed of an alternation of layers of different reflection coefficients and the reflection coefficient of which is maximum in the vicinity of the resonant frequency of the acoustic structure (24).

9. Resonant structure according to Claim 8, furthermore comprising a layer coating the structure, on the Bragg mirror (26, 28) at least.

10. Resonant structure according to one of Claims 1 to 9, wherein the first and/or second electrodes (16, 20) are metal layers deposited on or integrated into the carrier (12, 26) and the layer (18) of piezoelectric material, respectively.

11. Resonant acoustic structure according to one of Claims 1 to 10 associated with a variable capacitor.

12. Frequency filter comprising a set of a plurality of resonant structures according to one of the preceding claims.

13. Radio-frequency transponder (30) comprising an antenna (32, 34) associated with a resonant structure according to one of Claims 1 to 11 or with a filter according to Claim 12.

14. Transponder according to Claim 13, said transponder being associated with at least one second resonant acoustic structure according to one of Claims 1 to 11, the characteristics of each resonant structure allowing a differential temperature measurement to be carried out.

15. Transponder according to Claim 13, said transponder being associated with a least one resonant acoustic structure according to one of Claims 1 to 11, wherein the impedances of the various associated resonant acoustic structures differ by less than 10%.

16. Process for fabricating a resonant structure of HBAR type comprising placing a first electrode layer on a carrier (12, 26), placing a piezoelectric film (18) on the first electrode, placing a second electrode (20) on the piezoelectric film (18), and placing an additional layer (22) of material on the second electrode (20), the thickness e18 of the layer (18) of piezoelectric material being given by the relationship

$$e_{18} = (n' + x)\frac{V_{18}}{F_0}$$

where n' is a natural integer and preferably n' = 0, x is a real number lower than 1 and preferably x = 0.5, V18 is the propagation speed of the acoustic wave in the piezoelectric material and F0 is the operating frequency of the resonant structure (10), the thickness e22 of the additional layer (22) being defined by the relationship

$$e_{22} = \left[n''\frac{V_{22}}{2} + (1 - 2x')\frac{V_{22}}{4}\right]\frac{1}{F_0}$$

where n" is a natural integer and preferably n" = 1, V22 is the propagation speed of the acoustic wave in the additional layer (22), and x' = x $\pm$ 20% so as to optimize the acousto-electric density within the piezoelectric layer (18),
wherein the thickness e16 of the layer forming the first electrode (16) is smaller than $\lambda$16/20, where $\lambda$16 is the wavelength of the acoustic wave propagating inside the material of the first electrode (16),
wherein the thickness e20 of the layer forming the second electrode (20) is smaller than $\lambda_{20}$/20, where $\lambda_{20}$ is the wavelength of the acoustic wave propagating inside the material of the second electrode (20).

17. Process according to Claim 16, wherein the piezoelectric film (18) is bonded to the first electrode (16) by direct bonding.

18. Process according to either of Claims 16 and 17, wherein the first electrode (16) is deposited on a carrier comprising a planar substrate (12) made of single-crystal quartz.

19. Process according to either of Claims 16 and 17, wherein the first electrode (16) is deposited on a carrier comprising a Bragg mirror (26).

20. Process according to one of Claims 16 to 19, comprising placing a Bragg mirror (28) on the additional layer (22).

21. Process according to either of Claims 19 and 20, comprising coating the Bragg mirror (26, 28) at least.

FIG. 1

FIG. 2A

FIG. 2B

FIG. 2C

# FIG. 2D

# FIG. 3

FIG. 4

FIG. 5

FIG. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 4642508 A

• US 6087198 A

**Littérature non-brevet citée dans la description**

• **SHIH-YUNG PAO.** Analysis and experiment of HBAR frequency spectra and application to characterize the piezoelectric thin film and to HBAR design. *Proceedings of the IEEE International Frequency Control Symposium,* 2002, 8A-5